# EUROPÄISCHE PATENTSCHRIFT

(11) **EP 1 872 417 B1**
(45) Veröffentlichungstag und Bekanntmachung des Hinweises auf die Patenterteilung: **06.04.2011**
(21) Anmeldenummer: 06724491.3
(22) Anmeldetag: 21.04.2006
(51) Int. Cl.: H01L 51/40, C23C 14/04

(54) **VERFAHREN UND VORRICHTUNG ZUM HERSTELLEN VON ELEKTRONISCHEN BAUTEILEN**
METHOD AND DEVICE FOR PRODUCING ELECTRONIC COMPONENTS
PROCEDE ET DISPOSITIF POUR PRODUIRE DES COMPOSANTS ELECTRONIQUES

(30) Priorität: 22.04.2005 DE 102005018984
(43) Veröffentlichungstag der Anmeldung: 02.01.2008
(73) Patentinhaber: STEINER GMBH & Co. KG, D-57339 Erndtebrück (DE)
(72) Erfinder: TREUDE, Rolf, 57339 Erndtebrück (DE)
(74) Vertreter: Grosse, Wolf-Dietrich Rüdiger
(86) Internationale Anmeldenummer: PCT/EP2006/003678
(87) Internationale Veröffentlichungsnummer: WO 2006/111400

(56) Entgegenhaltungen:
- WO-A-2004/093002
- WO-A-2004/111729
- WO-A2-2005/043965
- DE-A1- 4 309 717
- JP-A- 2004 095 677
- US-B2- 6 838 153

## Beschreibung

Die Erfindung betrifft ein Verfahren zur Herstellung von elektronischen Bauteilen sowie eine Vorrichtung zur Durchführung des Verfahrens.

Durch die WO 02/31 214 A1 oder die EP 1 291 463 A1 sind Verfahren zur Metallisierung von Folien bekannt geworden, bei denen teilweise im Vakuum Metallschichten auf Trägerfolien aufgedampft werden. Als nachteilig hat sich hier jedoch erwiesen, dass als Sperrflüssigkeit eine Waschfarbe aufgebracht wird, die später außerhalb des Vakuums abgewaschen werden muss. Außerdem offenbaren diese Entgegenhaltungen keine Möglichkeit, aktive Bauelemente wie Feldeffekttransistoren herzustellen.

Durch die DE 100 33 112 A1 ist auch schon ein Verfahren zur Herstellung eines Feldeffekttransistors bekannt geworden. Hier werden jedoch Drucktechniken verwendet, um ein Substrat zu beschichten. Das Bedrucken des Substrats erfolgt bei normaler Atmosphäre, so dass die bedruckten Schichten äußerst leicht oxidieren, wodurch elektronischen Bauelemente von minderer Qualität entstehen.

Der Erfindung liegt die Aufgabe zugrunde, ein Verfahren aufzuzeigen, mittels dessen elektronische Bauelemente hergestellt werden können, die einerseits flexibel sind, andererseits optimale Wirkung zeigen und die kostengünstig und einfach in einem Arbeitsgang erstellt werden können.

Zur Lösung dieser Aufgabe wird ein Verfahren zum Herstellen von elektronischen Bauelementen in einem Vakuum vorgeschlagen, bei dem eine Trägerfolie mit einer Sperrflüssigkeit partiell bedruckt und anschließend einer Metallbedampfung ausgesetzt ist, wobei sich in der sperrschichtfreien Zone eine Metallschicht auf der Trägerfolie ablagert und die Sperrflüssigkeit während des Bedampfungsvorganges abdampft, bei dem anschließend auf die beschichtete Trägerfolie ein Halbleitermaterial durch einen weiteren Verdampfungsvorgang aufgedampft und darauf folgend eine Beschichtung mit flüssigem Acrylat vorgenommen wird, und bei dem im Anschluss daran nochmals die Sperrflüssigkeit partiell auf die Acrylatschicht aufgedruckt und darauf folgend eine Metallbedampfung vorgenommen wird und sich die vorbeschriebenen Beschichtungsvorgänge ggf. wiederholen und bei dem Verbindungen zwischen den einzelnen metallisierten Schichten herstellbar sind.

Das ganze Verfahren erfolgt in einem Vakuum, so dass keine Bereiche der aufgebrachten Schichten oxidieren können. Hinzu kommt, dass beim Beschichten durch Metallverdampfen reines Metall auf der Folie abgeschieden wird. Im Gegensatz zu den Druckverfahren, die ein Trägermedium für Metallpartikel aufweisen, ist eine erheblich höhere Konzentration an Metall in den Beschichtungsbereichen gegeben. Die Schichten können erheblich dünner aufgetragen werden. Außerdem lassen sich durch die Verwendung von Halbleitermaterial auch aktive Bauelemente, wie Feldeffekttransistoren herstellen.

Es hat sich bewährt, dass die Folie im Vakuum von einer Vorratsrolle abgewickelt und nach den entsprechenden Beschichtungsvorgängen auf einen Wickel aufgewickelt wird. Dadurch, dass das ganze Verfahren in einer Vakuumkammer im Rolle zu Rolle Verfahren erfolgt, ist ein möglichst geringer Verunreinigungseintrag gewährleistet.

Von Vorteil ist, dass der Ab- und / oder Aufwickelvorgang geregelt erfolgt. Dadurch lassen sich die einzelnen Verfahrensschritte, die ggf. unterschiedliche Zeitspannen beanspruchen, optimal aufeinander anpassen.

In vorteilhafter Weise wird der Dampfdruck und die Menge der Sperrflüssigkeit so gewählt, dass in der anschließenden Metallbeschichtungszone die Sperrflüssigkeit durch die Strahlungswärme der Verdampfungsquelle und durch die entstehende Kondensationswärme von der Trägerfolie abdampft. Durch die Dampfschicht der verdampfenden Sperrflüssigkeit an den zuvor mit der Sperrflüssigkeit benetzten Bereichen wird verhindert, dass sich der Metalldampf in diesen Bereichen niederschlagen kann.

Durch diese Maßnahme wird erreicht, dass im Anschluss an den Metallbeschichtungsvorgang keine oder kaum Reinigungsvorgänge erfolgen müssen.

Wird die Sperrschicht im Metallbedampfungsbereich bis zu ca. 95 % von der Trägerfolie abgedampft, so ist es sinnvoll, die Reste der Sperrschicht mittels Plasma von der Trägerfolie zu reinigen. Dabei entstehen jedoch nur geringste Mengen an abzunehmender Substanz. Mit dem Reinigen und Abwaschen der Waschfarbe der Verfahren nach dem Stand der Technik sind diese geringen Mengen nicht zu vergleichen.

Durch die Bedampfungstechnik lassen sich schon äußerst kleine Abstände zwischen benachbarten metallisierten Bereichen realisieren. Sollen jedoch besonders kleine Abstände zwischen zwei benachbarten metallisierten Bereichen realisiert werden, wird vorgeschlagen, einen metallisierten Bereich durch Ritzen mittels der Mikroritztechnik zu trennen, um so Unterbrechungen z. B. < 30 µm zu erreichen, die später durch das Halbleitermaterial ausgefüllt werden können. Dabei spielt die Breite des Halbleitermaterials zwischen den geritzten metallisierten Bereichen eine wesentliche Rolle bezüglich der Geschwindigkeit der hier entstehenden aktiven Bauteile.

Es hat sich bewährt, als Halbleitermaterial organisches Halbleitermaterial, z. B. Pentacen, zu verwenden.

Um die einzelnen Beschichtungsbereiche voneinander zu trennen und auch unterschiedliche Zeitabfolgen beim Beschichten gewährleisten zu können, hat es sich als vorteilhaft erwiesen, das Acrylat im Bereich einer zweiten Kühlwalze aufzubringen und das Acrylat mittels einer Elektronenstrahlkanone zum Polymerisieren anzuregen. Damit lassen sich optimale Zeiten für die einzelnen Beschichtungsphasen einregeln.

Es hat sich bewährt, wenn die aufgedampften Leiterbahnen der ersten Metallbeschichtung als Drain und Source eines Feldeffekttransistors (FET) und die aufgedampfte Leiterbahn der zweiten metallisierten Schicht als Gate Anwendung finden. Damit lässt sich durch möglichst geringen Aufwand sehr kostengünstig ein Feldeffekttransistor herstellen.

Es besteht aber auch die Möglichkeit, in weiteren Beschichtungsvorgängen dielektrisches Material aufzubringen. Dadurch lassen sich z. B. Kondensatoren verwirklichen.

Es hat sich aber auch bewährt, beim Herstellen der ersten oder zweiten aufgedampften Metallschichten Leiterbahnen, Widerstände, Spulen oder Antennen im gleichen Beschichtungsschritt mit herzustellen. Durch eine entsprechende Schaltung der einzelnen Elemente lassen sich ganze IC's oder komplette Baueinheiten wie Transponder herstellen.

Dabei hat sich bewährt, dass die Verbindungen zwischen den einzelnen metallisierten Schichten als Verbindungskanäle mittels Perforationswalzen erstellt werden. Die Verbindungskanäle werden durch einen späteren Bedampfungsvorgang mit Metall leitend gefüllt.

Von Vorteil ist, wenn die entsprechend beschichtete Folie letztendlich plasmagereinigt, funktionsgeprüft und im gleichen Vakuum auch noch wieder aufgewickelt wird. Damit lassen sich in einer Vakuumkammer die entsprechenden elektronischen Bauteile herstellen und auch noch auf ihre Funktionsfähigkeit überprüfen.

Eine vorteilhafte Vorrichtung zum Durchführen des Verfahrens wird in den Ansprüchen 15 bis 17 beschrieben.

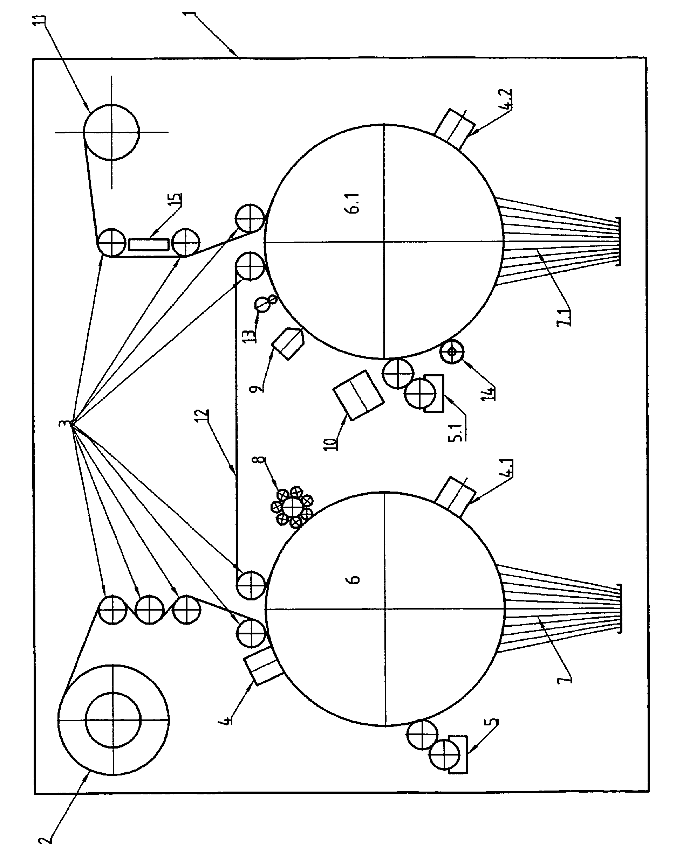

Die Erfindung wird anhand einer Zeichnung näher erläutert. Dabei zeigt die Figur eine Vakuumkammer 1, in der eine Abwickeleinheit 2 vorgesehen ist. Die Trägerfolie 12 wird über Rollen 3 wie Zugmessrollen, Breitsteckrollen und Umlenkrollen zur Kühlwalze 6 geleitet. Im Bereich der Kühlwalze 6 befindet sich eine Plasmareinigungsvorrichtung, welche die Trägerfolie 12 an der später zu beschichtenden Oberfläche reinigt. Im Anschluss daran ist eine Bedruckvorrichtung 5 vorgesehen, über welche Sperrflüssigkeit partiell und selektiv auf die Trägerfolie 12 aufgebracht wird. Die Trägerfolie 12 durchläuft im Anschluss daran eine Beschichtungszone 7, in der Metall verdampft wird und sich auf der nicht mit Sperrflüssigkeit benetzten Trägerfolie 12 absetzt. Durch die Strahlungswärme der Verdampfungsquelle und der entstehenden Kondensationswärme wird die Sperrflüssigkeit fast vollständig von der Trägerfolie 12 abgedampft. Noch auf der Trägerfolie 12 verbleibende Reste werden mit einer Plasmareinigungsvorrichtung 4.1 von der Trägerfolie 12 beseitigt.

Durch die Metallbedampfung der Trägerfolie im Vakuum lassen sich schon äußerst kleine Abstände zwischen benachbarten Bedampfungsbereichen erzielen. Sollen hier besonders kleine Abstände erreicht werden, können diese durch die Vorrichtung 8 zum Mikroritzen hergestellt werden. Die Trägerfolie 12 läuft im Anschluss an den Mikroritzvorgang von der Kühlwalze 6 zu einer zweiten Kühlwalze 6.1. Hier gelangt die Trägerfolie 12 an ein Verdampferrohr 13, über welches Halbleitermaterial auf die Oberfläche der partiell und selektiv beschichteten ggf. geritzten Oberfläche der Trägerfolie 12 aufgebracht wird. In Durchlaufrichtung der Trägerfolie 12 nach der Halbleiterbeschichtung erfolgt ein Aufbringen von Acrylat mittels einer Düse 9. Das Acrylat wird mit Elektronen einer Elektronenstrahlkanone 10 beaufschlagt, wodurch das Acrylat polymerisiert. Im Anschluss daran kann durch einen weiteren Druckvorgang partiell und selektiv Sperrflüssigkeit mittels der Druckvorrichtung 5.1 auf die Acrylatoberfläche der Trägerfolie 12 aufgebracht werden. Über eine Perforationswalze 14 können Verbindungskanäle durch die Acrylatschicht zur unteren metallisierten Schicht erstellt werden. Die Perforationswalze stellt diese Kanäle an vorgegebenen Stellen her. Im Anschluss daran wird die Oberfläche der Trägerfolie beschichtet. Dabei verdampft wieder die Sperrflüssigkeit und auf den nicht mit Sperrflüssigkeit versehenen Bereichen sowie den durch die Perforationswalze hergestellten Kanälen wird Metall abgeschieden. Reste der Sperrflüssigkeit können durch die Plasmareinigungsvorrichtung 4.2 entfernt werden.

An diese Kühlwalze können sich noch weitere Kühlwalzen, z. B. 6.2 bis 6.n anschließen, in deren Bereich Bedruck- und Beschichtungsvorgänge, ggf. auch in geänderter Reihenfolge durchgeführt werden können. Bevor die Trägerfolie 12 in der ebenfalls noch in der Vakuumkammer 1 befindlichen Aufwickeleinheit 11 aufgewickelt wird, passiert die Trägerfolie 12 eine Funktionsprüfungsstation 15, in der die einzelnen aufgebrachten elektronischen Bauteile funktionsgeprüft werden können.

### Bezugszeichenliste

- 1.: Vakuumkammer
- 2.: Abwickeleinheit
- 3.: Rollen
- 4.: Plasmareinigung
- 5.: Bedruckvorrichtung
- 6.: Kühlwalze
- 7.: Beschichtungszone
- 8.: Vorrichtung zum Mikroritzen
- 9.: Düse
- 10.: Elektronenstrahlkanone
- 11.: Aufwickeleinheit
- 12.: Trägerfolie
- 13.: Verdampferrohr
- 14.: Perforationswalze
- 15.: Vorrichtung zur Funktionsprüfung

## Patentansprüche

1. Verfahren zum Herstellen von elektronischen Bauteilen in einem Vakuum, wobei das ganze Verfahren in einer Vakuumkammer erfolgt, bei dem eine Trägerfolie (12) von einer Abwickeleinheit (2) abgewickelt, mit einer Sperrflüssigkeit partiell und/oder selektiv bedruckt und anschließend einer Metallbedampfung ausgesetzt ist, wobei ein Metall verdampft wird und sich in der sperrflüssigkeitfreien Zone eine Metallschicht auf der Trägerfolie (12) ablagert und die Sperrflüssigkeit während des Bedampfungsvorgangs abdampft,
bei dem anschließend auf die beschichtete Trägerfolie (12) ein Halbleitermaterial durch einen weiteren Verdampfungsvorgang aufgebracht und darauf folgend eine Beschichtung mit Acrylat vorgenommen wird,
bei dem im Anschluss daran nochmals die Sperrflüssigkeit partiell und/oder selektiv auf die Acrylatschicht aufgedruckt und darauf folgend eine Metallbedampfung vorgenommen wird,
bei dem an vorgegebenen Stellen leitende Verbindungen zwischen den einzelnen metallisierten Schichten hergestellt werden,
und bei dem die Trägerfolie (12) im Vakuum nach dem Beschichtungsvorgang auf einen Wickel aufgewickelt wird.

2. Verfahren nach Anspruch 1,
**dadurch gekennzeichnet,**
**dass** der Ab- und / oder Aufwickelvorgang geregelt erfolgt.

3. Verfahren nach Anspruch 1 oder 2,
**dadurch gekennzeichnet,**
**dass** die Trägerfolie (12) über Rollen (3) wie Zugmessrollen, Breitstreckrollen, Umlenkrollen, zu einer Kühlwalze (6, 6.1) geführt wird und dass die Metallbedampfung im Bereich der Kühlwalze (6,6.1) erfolgt.

4. Verfahren nach einem der Ansprüche 1 bis 3,
**dadurch gekennzeichnet,**
**dass** der Dampfdruck und die Menge der Sperrflüssigkeit so gewählt ist, dass in der anschließenden Metallbeschichtungszone (7) die Sperrflüssigkeit durch die Strahlungswärme der Verdampfungsquelle und der entstehenden Kondensationswärme von der Trägerfolie (12) abdampft und durch die Dampfschicht der verdampfenden Sperrflüssigkeit an den zuvor mit Sperrflüssigkeit benetzten Bereichen verhindert wird, dass sich der Metalldampf in diesen Bereichen niederschlagen kann,

5. Verfahren nach einem der Ansprüche 1 bis 4,
**dadurch gekennzeichnet,**
**dass** die Sperrflüssigkeit in der Metallbeschichtungszone (10) bis zu ca. 95 % von der Trägerfolie (12) abdampft und dass die Trägerfolie (12) mittels Plasma von dem Rest der Sperrflüssigkeit gereinigt wird.

6. Verfahren nach einem der Ansprüche 1 bis 5,
**dadurch gekennzeichnet,**
**dass** besonders kleine Abstände kleiner als 30 µm zwischen zwei benachbarten metallisierten Bereichen durch Ritzen der aufgedampften Metallschicht mittels der Mikrorltztechnik erstellt werden.

7. Verfahren nach einem der Ansprüche 1 bis 6,
**dadurch gekennzeichnet,**
**dass** als Halbleitermaterial organisches Halbleitermaterial Anwendung findet.

8. Verfahren nach Anspruch 7,
**dadurch gekennzeichnet,**
**dass** als organisches Halbleitermaterial Pentacen Anwendung findet.

9. Verfahren nach einem der Ansprüche 1 bis 8,
**dadurch gekennzeichnet,**
**dass** die Beschichtung mit einem flüssigen Acrylat im Bereich einer zweiten Kühlwalze (6.1) erfolgt und dass das Acrylat mittels einer Elektronenstrahlkanone (10) zum Polymerisieren angeregt wird.

10. Verfahren nach einem der Ansprüche 1 bis 9,
**dadurch gekennzeichnet,**
**dass** die aufgedampften Leiterbahnen der ersten metallisierten Schicht als Drain und Source eines Feldeffekttransistors und die aufgedampfte Leiterbahn der zweiten metallisierten Schicht als Gate Anwendung findet.

11. Verfahren nach einem der Ansprüche 1 bis 10,
**dadurch gekennzeichnet,**
**dass** in weiteren Beschichtungsvorgängen dielektrisches Material aufgedampft wird.

12. Verfahren nach einem der Ansprüche 1 bis 11,
**dadurch gekennzeichnet,**
**dass** die Leiterbahnen neben der Funktion eines Feldeffekttransistors als Widerstand, Spule, Kondensator oder Antenne ausgebildet wird.

13. Verfahren nach einem der Ansprüche 1 bis 11,
**dadurch gekennzeichnet,**
**dass** die leitenden Verbindungen zwischen den einzelnen metallisierten Schichten als Verbindungskanäle mittels Perforationswalzen (14) erstellt werden, in denen beim anschließenden Metallverdampfungs-/ Metallbedampfungsvorgang Metall abgeschieden wird.

14. Verfahren nach einem der Ansprüche 1 bis 13,
**dadurch gekennzeichnet,**
**dass** die beschichtete Trägerfolle (12) letztendlich plasmagereinigt, einer Funktionsprüfung unterzogen und im Vakuum aufgewickelt wird,

15. Vorrichtung zum Durchführen des Verfahrens nach einem der Ansprüche 1 bis 14,
**gekennzeichnet durch** eine Vakuumkammer (1), darin angeordnet ein Abwlckeleinheit (2), eine Kühlwalze (6), eine Bedruckvorrichtung (5) zum Bedrucken der Trägerfolie (12) mit Sperrflüssigkeit, eine Metallbeschichtungsvorrichtung (7), einer Vorrichtung zum Mikroritzen mittels der kleinste Abstände kleiner 30 µm zwischen benachbarten metallisierten Bereichen erstellt werden, ein Halbleitermedium-Verdampferrohr (13) im Bereich einer weiteren Kühlwalze (6.1), eine Beschichtungsdüse (9) zum Beschichten der Trägerfolie (12) mit Acrylat, eine Elektronenstrahlkanone (10) zum Polymerisieren des Acrylats, eine weitere Bedruckvorrichtung (5.1) zum partiellen und/oder selektiven Bedrucken des Acrylats mit einer Sperrflüssigkeit, eine Perforationswalze (14) zum Herstellen von Verbindungskanälen zwischen einzelnen Metallisierungsschichten, eine weitere Metallbeschichtungszone (7.1), sowie eine Aufwickeleinheit (11).

16. Vorrichtung nach Anspruch 15,
**gekennzeichnet durch** Vorrichtungen (4,4.1, 4,2) zum Plasmareinigen.

17. Vorrichtung nach Anspruch 15 oder 16,
**dadurch gekennzeichnet,**
**dass** vor der Aufwickeleinheit (11) eine Einheit (15) zur Funktionsprüfung vorgesehen ist.

## Claims

1. A method for producing electronic components in a vacuum, wherein the entire method takes place inside a vacuum chamber, in which a carrier film (12) is unwound from an unwinding unit (2), partially and/or selectively imprinted with a barrier liquid and then subjected to vacuum metallisation, wherein a metal is vaporised and a layer of metal is deposited on the carrier film (12) in the zone where the barrier liquid is absent and the barrier liquid evaporates during the vacuum metallisation process, in which a semiconductor material is subsequently applied to the coated carrier film (12) in a further vaporisation process and coating with acrylate is then carried out, in which the barrier liquid is then applied partially and/or selectively to the acrylate layer again and a further vacuum metallisation process is performed, in which conducting connections are created at defined sites between the individual metallised layers, and in which the carrier film (12) is wound onto a winding reel under vacuum following the coating operation.

2. The method as recited in claim 1, **characterized in that** the unwinding and winding operation is controlled.

3. The method as recited in claim 1 or 2, **characterized in that** the carrier film (12) is guided via rollers (3) such as tension measuring rollers, stretcher rollers, deflection rollers to a cooling roller (6, 6.1), and that the vacuum metallisation takes place in the area of the cooling roller (6, 6.1).

4. The method as recited in any of claims 1 to 3, **characterized in that** the vapour pressure and the quantity of barrier liquid is selected such that in the following metal coating zone (7) the barrier liquid is evaporated by the radiated heat of from the evaporation source and the resulting condensation heat from the carrier film (12), and the vapour layer of the evaporating barrier liquid in the areas coated previously with barrier liquid prevents the metal vapour from being precipitated in these areas.

5. The method as recited in any of claims 1 to 4, **characterized in that** up to about 95% of the barrier liquid is evaporated from the carrier film (12) in the metallisation zone (10) and that the remaining barrier liquid is cleaned from the carrier film (12) using plasma.

6. The method as recited in claim 4 or 5, **characterized in that** particularly small spaces, smaller than 30 µm, are created between two adjacent metallised areas by scoring the vapour deposited metal layer using a microscoring technique.

7. The method as recited in any of claims 1 to 6, **characterized in that** organic semiconductor material is used as the semiconductor material.

8. The method as recited in claim 7, **characterized in that** pentacene is used as the organic semiconductor material.

9. The method as recited in any of claims 1 to 8, **characterized in that** the coating with a liquid acrylate takes place in the area of a second cooling roller (6.1) and that polymerisation of the acrylate is initiated via an electron beam gun (10).

10. The method as recited in any of claims 1 to 9, **characterized in that** the vapour-deposited conductor tracks of the first metallised layer serve as the drain and source of a field effect transistor and the vapour-deposited conductor track of the second metallised layer serves as a gate.

11. The method as recited in any of claims 1 to 10, **characterized in that** dielectric material is vapour-deposited in subsequent coating operations.

12. The method as recited in any of claims 1 to 11, **characterized in that** the conductor tracks are also designed as a resistor, inductor, capacitor or antenna in addition to the function of a field effect transistor.

13. The method as recited in any of claims 1 to 11, **characterized in that** the conductive connections between the individual metallised layers are produced as connecting channels via perforation rollers (14), in which metal is separated in the subsequent metal vaporisation/vacuum metallisation process.

14. The method as recited in any of claims 1 to 13, **characterized in that** the coated carrier film (12) is finally cleaned with plasma, subjected to functional testing and wound up in a vacuum.

15. A device for performing the method as recited in any of claims 1 to 14, **characterized by** a vacuum chamber (1) having an unwinding unit (2), a cooling roller (6), an imprinting device (5) for imprinting the carrier film (12) with barrier liquid, a metal coating device (7), a microscoring device with which extremely small distances, less than 30 µm, are created between adjacent metallised areas, a semiconductor medium vaporiser tube (13) in the area of a further cooling roller (6.1), a coating nozzle (9) for coating a carrier film (12) with acrylate, an electron beam gun (10) for polymerising the acrylate, a further imprinting device (5.1) for partial and/or selective imprinting of the acrylate with a barrier liquid, a perforation roller (14) for producing connecting channels between individual metallisation layers, a further metal coating zone (7.1), and a take-up winding unit (11) arranged therein.

16. The device as recited in claim 15, **characterized by** plasma cleaning devices (4, 4.1, 4.2).

17. The device as recited in claim 15 or 16, **characterized in that** a unit (15) for functional testing is provided before the take-up winding unit (11) to test function.

## Revendications

1. procédé de fabrication de composants électroniques sous vide, l'ensemble du procédé s'effectuant dans une chambre à vide, lors duquel un film support (12) est déroulé d'une unité dérouleuse (2), est imprimé en surcharge, partiellement et/ou de façon sélective d'un liquide obturant, puis est exposé à une métallisation sous vide, un métal étant vaporisé et dans la zone exempte de liquide obturant, une couche métallique se déposant sur le film support (12) et le liquide obturant s'évaporant pendant le processus de métallisation sous vide,
lors duquel, par la suite on applique par un autre processus de métallisation sous vide un matériau semi-conducteur sur le film support (12), suite à quoi, on procède à un revêtement par acrylate,
lors duquel on réimprime par la suite encore une fois en surcharge le liquide obturant partiellement et/ou de façon sélective sur la couche d'acrylate, suite à quoi, on procède à une métallisation sous vide,
lors duquel, on établit en des endroits prédéfinis des liaisons conductrices entre les couches métallisées individuelles,
et lors duquel, après le processus de revêtement, on enroule le film support (12) sous vide sur un bobinage.

2. Procédé selon la revendication 1, **caractérisé en ce que** le processus de déroulement et / ou d'enroulement est réglé.

3. Procédé selon la revendication 1 ou 2, **caractérisé en ce que** le film support (12) est guidé par l'intermédiaire de cylindres (3) comme des cylindres de mesure de la traction, des cylindres élargisseurs, des cylindres de renvoi vers un tambour de refroidissement (6, 6.1) et **en ce que** la métallisation sous vide s'effectue dans la région du tambour de refroidissement (6, 6.1).

4. Procédé selon l'une quelconque des revendications 1 à 3, **caractérisé en ce que** la pression de la vapeur et la quantité de liquide obturant sont choisis de sorte que dans la zone de métallisation (7) sous vide qui s'y raccorde, le liquide obturant s'évapore du film support (12) par la chaleur radiante de la source de métallisation sous vide et par la chaleur de condensation et **en ce que** par la couche de vapeur du liquide obturant qui s'évapore, il est évité que la vapeur métallique ne puisse se déposer dans ces zones.

5. Procédé selon l'une quelconque des revendications 1 à 4, **caractérisé en ce que** dans la zone de métallisation sous vide (10), le liquide obturant s'évapore à environ 95 % du film support (12) et **en ce que** le film support (12) est nettoyé au plasma du reste du liquide obturant.

6. Procédé selon l'une quelconque des revendications 1 à 5, **caractérisé en ce que** des écarts particulièrement petits, inférieurs à 30 µm sont établis entre deux zones métallisées par pratique d'incisions dans la couche métallique appliquée, au moyen de la technique par micro-incision.

7. Procédé selon l'une quelconque des revendications 1 à 6, **caractérisé en ce qu'**on utilise en tant que matériau semi-conducteur un matériau semi-conducteur organique.

8. Procédé selon l'une quelconque des revendications 1 à 6, **caractérisé en ce qu'**on utilise comme matériau semi-conducteur organique du pentacène.

9. Procédé selon l'une quelconque des revendications 1 à 8, **caractérisé en ce que** le revêtement d'un acrylate liquide s'effectue dans la région d'un tambour de refroidissement (6.1) et **en ce que** l'acrylate est incité à la polymérisation au moyen d'un canon à bombardement électronique (10).

10. Procédé selon l'une quelconque des revendications 1 à 9, **caractérisé en ce que** les pistes conductrices de la première couche métallisée sont utilisées comme drain et source d'un transistor à effet de champ et **en ce que** les pistes conductrices métallisées sous vide de la deuxième couche métallisée sont utilisées comme intersecteur de circuit logique.

11. Procédé selon l'une quelconque des revendications 1 à 10, **caractérisé en ce que** du matériau diélectrique est métallisé sous vide lors de processus de revêtement suivant.

12. Procédé selon l'une quelconque des revendications 1 à 11, **caractérisé, en ce que** parallèlement à la fonction d'un transistor à effet de champ, les pistes conductrices sont conçues sous la forme de résistance, de bobine, de condensateur ou d'antenne.

13. Procédé selon l'une quelconque des revendications 1 à 11, **caractérisé en ce que** les liaisons conductrices entre les couches métallisées individuelles sont réalisées au moyen de rouleaux de perforation (14) comme canaux de liaison dans lesquels au cours du processus suivant d'évaporation métallique / de métallisation sous vide du métal est séparé.

14. Procédé selon l'une quelconque des revendications 1 à 13, **caractérisé en ce que** le film support (12) revêtu, finalement nettoyé au plasma est soumis à un contrôle fonctionnel, puis enroulé sous vide.

15. Dispositif pour la réalisation du procédé selon l'une quelconque des revendications 1 à 14, **caractérisé par** une chambre sous vide (1), disposés dans cette dernière, une unité de déroulement (2), un tambour de refroidissement (6), un dispositif d'impression (5) pour imprimer le film support (12) de liquide obturant, un dispositif de revêtement par métal (7), un dispositif de micro-incision au moyen duquel des plus petits écarts inférieurs à 30 µm sont créés entre des zones métallisées, un tube de vaporisation de milieu semi-conducteur (13) dans la région d'un autre tambour de refroidissement (6.1), une buse de revêtement (9) pour revêtir le film support (12) d'acrylate, un canon de bombardement électronique (10) pour polymériser l'acrylate, un autre dispositif d'impression (5.1) pour l'impression partielle et/ou sélective de l'acrylate d'un liquide obturant, un rouleau de perforation (14) pour créer des canaux de liaison entre des couches de métallisation individuelles, une autre zone de revêtement par métal (7.1), ainsi qu'une unité d'enroulement (11).

16. Dispositif selon la revendication 15, **caractérisé par** des dispositifs (4, 4.1, 4.2) pour le nettoyage plasma.

17. Dispositif selon la revendication 15 ou 16, **caractérisé en ce qu'**en amont de l'unité d'enroulement (11), il est prévu une unité (15) pour le contrôle fonctionnel.
